# EUROPEAN PATENT APPLICATION

(11) **EP 2 663 170 A2**
(43) Date of publication of application: **13.11.2013**
(21) Application number: 12177349.3
(22) Date of filing: 20.07.2012
(51) Int. Cl.: H05K 5/00, F16B 5/06

(54) **Fastening means, fastening arrangement and method for establishing a fastening arrangement**

(30) Priority: 10.05.2012 DE 102012009303
(71) Applicant: Johnson Controls GmbH, 51399 Burscheid (DE)
(72) Inventor: Bieletzki-Welz, Viktor, 42799 Leichlingen (DE); Zhelyazkova, Kristina, 1784 Sofia (BG)
(74) Representative: Liedtke, Markus

(57) **Abstract**

The invention relates to a fastening means (1) comprising a plurality of snap hooks (8, 14), snap tabs (16, 17, 22), snap means (25) and retaining recesses (6, 12, 11, 21) for arranging and connecting a plurality of components (18, 19, 23, 24) at the fastening means (1). Moreover, the invention relates to a fastening arrangement and a method for establishing it, comprising:
- arranging a first component (18) on a second component (19) by inserting the second component (19) at least partially in a hook shaped moulding) arranged on the first component (18),
- fitting a fastening means (1) in the area of the hook shaped moulding such that the first component (18) and the second component (19) are arranged in a retaining section (21) of the fastening means (1), wherein snap tabs (22) on the second component (19) form a positive and/or non-positive snap lock to snap hooks (14) on the fastening means (1),
- arranging a third component (23) between snap hooks (8) and snap tabs (16) arranged on a rear side of the fastening means (1) facing away from the snap lock between the second component (19) and the fastening means (1),
- inserting the fourth component (24) onto the fastening means (1) and the attached first, second and third component (18, 19, 23) such that snap tabs (17) of the fastening means (1) form a positive and or non-positive snap lock with corresponding snap means (25) of the fourth component (24).

## Description

The invention relates to a fastening means, a fastening arrangement comprising a fastening means and a method for establishing a fastening arrangement comprising a fastening means.

Conventional art components are mutually coupled by means of separate fastening means and thus composed to form a component assembly.

The object of the present invention is to provide an improved fastening means, an improved fastening arrangement comprising a fastening means and an improved method for establishing a fastening arrangement comprising a fastening means.

The object is achieved by a fastening means according to claim 1, a fastening arrangement according to claim 11 and a method for establishing a fastening arrangement according to claim 14.

According to the invention a fastening means is arranged to mechanically couple a plurality of components mutually and/or with the fastening means. For this purpose the fastening means comprises a plurality of snap hooks, snap tabs and snap means. Furthermore, the fastening means exhibits variously shaped retaining recesses for arranging a plurality of components at the fastening means.

In order to establish a fastening arrangement a first component is arranged on a second component. For this purpose the first component comprises a hook shaped recess, in which the second component is inserted. Thus, the first component encloses the second component in sections. Subsequently, the fastening means is fit in the area of this enclosure of the second component by the first component such that the first and the second component are arranged in a retaining section of the fastening means. On the second component snap tabs are arranged which form a positive and/or non-positive lock with snap hooks of the fastening means.

The third component is arranged between the respective snap hooks and snap tabs on the side of the fastening means facing away from the snap lock between the second component and the fastening means.

The fourth component is inserted onto the fastening means and the attached components such that the snap tabs of the fastening means form a snap lock with the corresponding snap means of the fourth component.

This allows for a vibration resistant and reversible mutual connection of a plurality of components.

Moreover, a separate mutual coupling between the components is avoided thus simplifying assembly and reducing assembly time.

Preferably, applying a number of fastening means for coupling a plurality of components is avoided since by means of a single fastening means according to the invention a plurality of components, in particular four components, may be mutually coupled, directly or indirectly.

Coupling the components by a plurality of screw or glue connections is thus avoided.

The fastening means allows for fixing a multitude of components, e.g. four components together in such a manner that tolerances are eliminated by adding the last, e.g. the fourth component. Eliminating tolerances prevents unwanted relative movement between the components and resulting noise and vibrations. Thus an overall quality of the fastening arrangement is improved. The resulting fastening arrangement may operate in low and high G loading forces caused by acceleration and deceleration without reaching a resonance due to tolerances since these are eliminated.

In an exemplary embodiment the fastening means comprises a flat, tab shaped base body.

In an exemplary embodiment at a lower end of the base body a recess is arranged in the base body in such a manner that two brackets are formed, wherein a snap hook is arranged on each bracket such that on both sides of the lower end of the base body a respective snap hook is arranged.

In an exemplary embodiment a snap tab is formed on each bracket at a rear side of the base body opposite a face side.

In an exemplary embodiment in a centre section the base body a hook shaped moulding protrudes from the face side, wherein the hook shaped bracket comprises a coupling section, protruding from the base body, and a retaining section arranged basically in parallel to the base body in a defined or definable distance thus forming a retaining section between the retaining section and the brackets.

In an exemplary embodiment of at a lower end of the retaining section a recess is arranged in the retaining section thus forming two brackets, wherein at each bracket a further snap hook is formed such that on both sides of the lower end of the retaining section a respective further snap hook is arranged. In an exemplary embodiment of above the recess two retaining tabs are formed on a face side of the retaining section.

In an exemplary embodiment at an upper end of the base body a moulding protrudes at an angle facing away from the face side of the fastening means.

In an exemplary embodiment the moulding is arranged as a support element for supporting at least one of the components to be coupled to the fastening means in order to form the fastening arrangement.

The fastening means may comprise or be made of plastics, a plastic composite and/or a metal.

According to another aspect of the invention the fastening arrangement comprises:
- a first component and a second component, wherein the second component is at least partially inserted in a hook shaped moulding arranged on the first component,
- the fastening means, wherein the fastening means is fit in the area of the hook shaped moulding such that the first component and the second component are arranged in the retaining section of the fastening means, wherein snap tabs on the second component form a positive and/or non-positive snap lock to the snap hooks on the fastening means,
- a third component arranged between the snap hooks and snap tabs arranged on the rear side of the fastening means facing away from the snap lock between the second component and the fastening means,
- a fourth component inserted onto the fastening means and the attached first second and third component such that the snap tabs of the fastening means form a positive and or non-positive snap lock with corresponding snap means of the fourth component.

In an exemplary embodiment a distance between the snap hooks and the snap tabs basically equals a height of the third component such that the third component is positively and/or non-positively locked between the snap hooks and the snap tabs.

Preferably, the first component is arranged as a back cover or a frame element of a multifunction display unit. The second component is arranged as a light housing or as a reflector. The third component is arranged as an electronic printed circuit board and the fourth component is arranged as a front cover or front mask.

According to yet another aspect of the invention a method for establishing a fastening arrangement comprises:
- arranging a first component on a second component by inserting the second component at least partially in a hook shaped moulding arranged on the first component,
- fitting a fastening means in the area of the hook shaped moulding such that the first component and the second component are arranged in a retaining section of the fastening means, wherein snap tabs on the second component form a positive and/or non-positive snap lock to snap hooks on the fastening means,
- arranging a third component between snap hooks and snap tabs arranged on a rear side of the fastening means facing away from the snap lock between the second component and the fastening means,
- inserting the fourth component onto the fastening means and the attached first, second and third component such that snap tabs of the fastening means form a positive and or non-positive snap lock with corresponding snap means of the fourth component.

The present invention will become more fully understood from the detailed description given hereinbelow and the accompanying drawings which are given by way of illustration only, and thus, are not limitive of the present invention, and wherein:
- Fig. 1: is a schematic perspective view of a fastening means according to the invention,
- Fig. 2: is a schematic perspective view of a fastening arrangement according to the invention comprising a fastening means,
- Fig. 3: is a schematic detail view of an arrangement of a third component on the fastening means,
- Fig. 4: is a schematic detail view of a snap connection between a second component and the fastening means,
- Fig. 5: is a schematic sectional view of the fastening arrangement, and
- Fig. 6: is a schematic perspective detail view of the fastening arrangement.

Corresponding parts are marked with the same reference symbols in all figures.

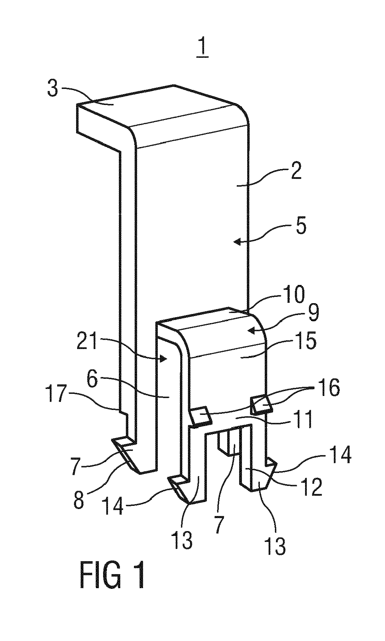

Figure 1 is a schematic perspective view of a fastening means 1 according to the invention.

The fastening means 1 is preferably made of plastic or a plastic composite. Likewise the fastening means may comprise or be made of a metal.

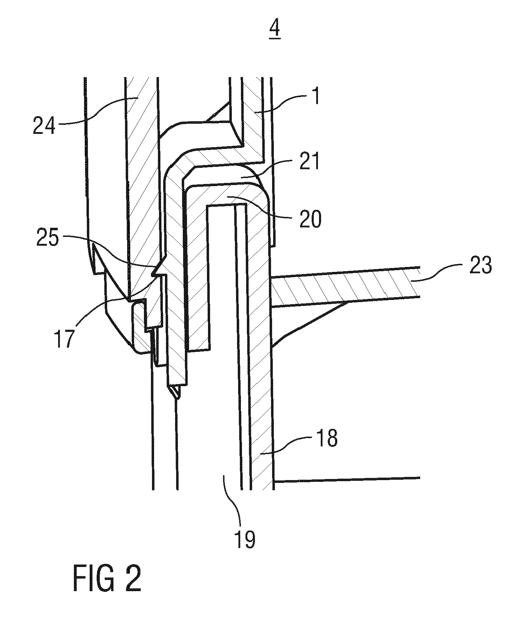

Figure 2 is a schematic perspective view of a fastening arrangement 4 according to the invention comprising a fastening means 1.

The fastening means 1 comprises a flat, tab shaped base body 2. At an upper end of the base body 2 a moulding 3 protrudes at an angle, preferably at right angles from the base body 2. The moulding 3 protrudes facing away from a face side 5 of the fastening means 1.

The moulding may for example serve as a grip element when establishing the fastening arrangement 4.

The moulding 3 may also be arranged as a support element for supporting at least one of the components coupled in the fastening arrangement 4.

At the lower end of the base body 2 a recess 6 is arranged in the base body 2 in such a manner that two brackets 7 are formed. A snap hook 8 is arranged on each bracket 7 such that on both sides of the lower end of the base body 2 a respective snap hook 8 is arranged.

A snap tab 17 is formed on each bracket 7 at the rear side of the base body 2.

In a centre section the base body 2 comprises a hook shaped moulding 9. The hook shaped moulding 9 is arranged on the face side 5 of the base body 2 thus forming a retaining section 21 between the hook shaped moulding 9 and the brackets 7.

The hook shaped bracket 9 comprises a coupling section 10, protruding at right angles from the base body 2, and a retaining section 11 arranged in parallel to the base body 2 in a defined or definable distance.

At a lower end of the retaining section 11 a recess 12 is arranged in the retaining section 11 thus forming two brackets 13. At each bracket 13 a further snap hook 14 is formed such that on both sides of the lower end of the retaining section 11 a respective further snap hook 14 is arranged.

Preferably, above the recess 12 two retaining tabs 16 are formed on the face side 15 of the retaining section 11.

Figure 2 is a schematic perspective view of a fastening arrangement 4 according to the invention comprising the fastening means 1.

In order to establish the fastening arrangement 4 a first component 18 is arranged on a second component 19. For this purpose the first component 18 comprises a hook shaped moulding 20, in which the second component 19 is inserted.

Thus, the first component 18 encloses the second component 19 partially or in sections. Subsequently, the fastening means 1 is fit in the area of this enclosure of the second component 19 by the first component 18 such that the first component 18 and the second component 19 are arranged in the retaining section 21 of the fastening means 1.

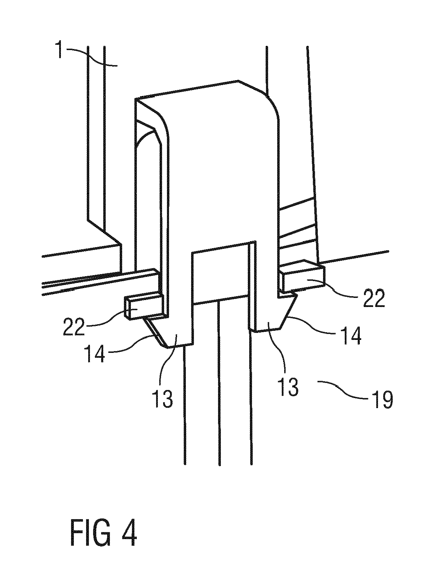

As illustrated in figure 4 on the second component 19 snap tabs 22 are formed corresponding to the snap hooks 14 of the fastening means 1 such that they respectively form a positive and/or non-positive lock, in particular a snap lock with these snap hooks 14.

Thus, the first component 18 and the second component 19 are attached to each other by the fastening means 1, wherein this coupling is locked by means of the snap lock between the snap tabs 22 and the snap hooks 14. Figure 4 is a schematic detail view of a snap connection between the second component 19 and the fastening means 1.

A third component 23 is arranged between the respective snap hooks 8 and snap tabs 16 on the rear side of the fastening means 1 facing away from the snap lock between the second component 19 and the fastening means 1. A distance between the snap hooks 8 and the snap tabs 16 preferably equals a height of the third component 23 such that the third component 23 is positively and/or non-positively locked between the snap hooks 8 and the snap tabs 16.

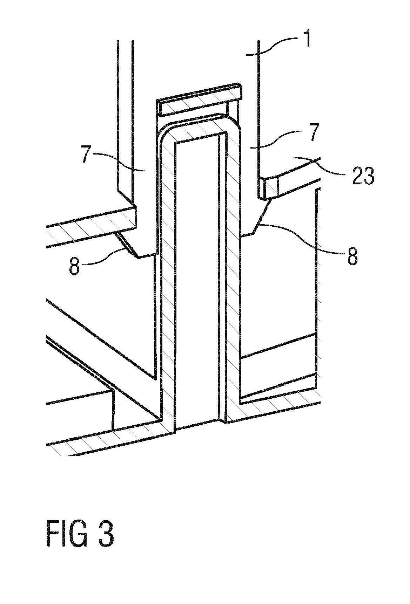

Figure 3 is a schematic detail view of an arrangement of the third component 23 on the fastening means 1.

The fourth component 24 is inserted onto the fastening means 1 and the attached components 18, 19, 23 such that the snap tabs 17 of the fastening means 1 form a positive and or non-positive snap lock with the corresponding snap means 25 of the fourth component 24.

Preferably, the first component 18 is arranged as a back cover or a frame element of a multifunction display unit. The second component 19 is arranged as a light housing or as a reflector. The third component 23 is arranged as an electronic printed circuit board and the fourth component 24 is arranged as a front cover or front mask.

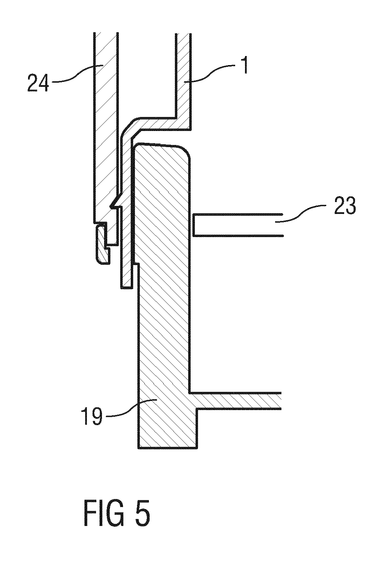

Figure 5 is a schematic sectional view of the fastening arrangement 4.

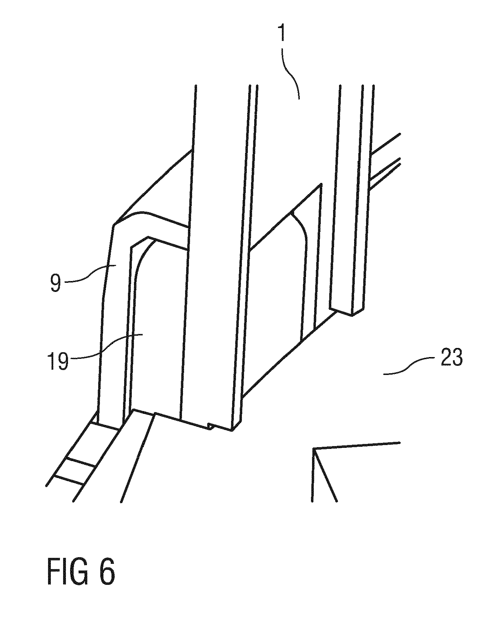

Figure 6 is a schematic perspective detail view of the fastening arrangement 4.

It goes without saying that in all mutual engagements comprising a lock between a snap hook and a snap tab the position of the snap hook and snap tab may be switched between the involved two components to be attached to each other.

It also goes without saying that in all cases where one component is inserted in a hook shaped recess of another so as to be partially enclosed by the other component the hook shaped recess may also be switched to the one component so as to partially enclose the other component within.

### List of references

- 1: fastening means
- 2: base body
- 3: moulding
- 4: fastening arrangement
- 5: face side
- 6: recess
- 7: bracket
- 8: snap hook
- 9: hook shaped moulding
- 10: coupling section
- 11: retaining section
- 12: recess
- 13: bracket
- 14: further snap hook
- 15: face side
- 16: retaining tab
- 17: snap tab
- 18: first component
- 19: second component
- 20: hook shaped moulding
- 21: retaining section
- 22: snap tab
- 23: third component
- 24: fourth component
- 25: snap means

## Claims

1. Fastening means (1) comprising a plurality of snap hooks (8, 14), snap tabs (16, 17, 22), snap means (25) and retaining recesses (6, 12, 11, 21) for arranging and connecting a plurality of components (18, 19, 23, 24) at the fastening means (1).

2. Fastening means (1) according to claim 1, **characterized in** a flat, tab shaped base body (2).

3. Fastening means (1) according to claim 2, **characterized in that** at a lower end of the base body (2) a recess (6) is arranged in the base body (2) in such a manner that two brackets (7) are formed, wherein a snap hook (8) is arranged on each bracket (7) such that on both sides of the lower end of the base body (2) a respective snap hook (8) is arranged.

4. Fastening means (1) according to claim 3, **characterized in that** a snap tab (17) is formed on each bracket (7) at a rear side of the base body (2) opposite a face side (5).

5. Fastening means (1) according to claim 4, **characterized in that** in a centre section the base body (2) a hook shaped moulding (9) protrudes from the face side (5), wherein the hook shaped bracket (9) comprises a coupling section (10), protruding from the base body (2), and a retaining section (11) arranged basically in parallel to the base body (2) in a defined or definable distance thus forming a retaining section (21) between the retaining section (11) and the brackets (7).

6. Fastening means (1) according to claim 5, **characterized in that** at a lower end of the retaining section (11) a recess (12) is arranged in the retaining section (11) thus forming two brackets (13), wherein at each bracket (13) a further snap hook (14) is formed such that on both sides of the lower end of the retaining section (11) a respective further snap hook (14) is arranged.

7. Fastening means (1) according to claim 6, **characterized in that** above the recess (12) two retaining tabs (16) are formed on a face side (15) of the retaining section (11).

8. Fastening means (1) according to one of the preceding claims, **characterized in that** at an upper end of the base body (2) a moulding (3) protrudes at an angle facing away from the face side (5) of the fastening means (1).

9. Fastening means (1) according to claim 8, **characterized in that** the moulding (3) is arranged as a support element for supporting at least one of the components (18, 19, 23, 24) to be coupled to the fastening means (1).

10. Fastening means (1) according to one of the preceding claims, **characterized in that** the fastening means (1) comprises or is made of plastics, a plastic composite and/or a metal.

11. Fastening arrangement (4) comprising:
- a first component (18) and a second component (19), wherein the second component (19) is at least partially inserted in a hook shaped moulding (20) arranged on the first component (18),
- a fastening means (1) according to one of the claims 7 to 10, wherein the fastening means (1) is fit in the area of the hook shaped moulding (20) such that the first component (18) and the second component (19) are arranged in the retaining section (21) of the fastening means (1), wherein snap tabs (22) on the second component (19) form a positive and/or non-positive snap lock to the snap hooks (14) on the fastening means (1),
- a third component (23) arranged between the snap hooks (8) and snap tabs (16) arranged on the rear side of the fastening means (1) facing away from the snap lock between the second component (19) and the fastening means (1),
- a fourth component (24) inserted onto the fastening means (1) and the attached first second and third component (18, 19, 23) such that the snap tabs (17) of the fastening means (1) form a positive and or non-positive snap lock with corresponding snap means (25) of the fourth component (24).

12. Fastening arrangement (4) according to claim 11, **characterized in that** a distance between the snap hooks (8) and the snap tabs (16) basically equals a height of the third component (23) such that the third component (23) is positively and/or non-positively locked between the snap hooks (8) and the snap tabs (16).

13. Fastening arrangement (4) according to one of the claims 11 or 12, **characterized in that** the first component (18) is arranged as a back cover or a frame element of a multifunction display unit, wherein the second component (19) is arranged as a light housing or as a reflector, wherein the third component (23) is arranged as an electronic printed circuit board and wherein the fourth component (24) is arranged as a front cover or front mask.

14. Method for establishing a fastening arrangement (4), comprising:
- arranging a first component (18) on a second component (19) by inserting the second component (19) at least partially in a hook shaped moulding (20) arranged on the first component (18),
- fitting a fastening means (1) in the area of the hook shaped moulding (20) such that the first component (18) and the second component (19) are arranged in a retaining section (21) of the fastening means (1), wherein snap tabs (22) on the second component (19) form a positive and/or non-positive snap lock to snap hooks (14) on the fastening means (1)_{,}
- arranging a third component (23) between snap hooks (8) and snap tabs (16) arranged on a rear side of the fastening means (1) facing away from the snap lock between the second component (19) and the fastening means (1),
- inserting the fourth component (24) onto the fastening means (1) and the attached first, second and third component (18, 19, 23) such that snap tabs (17) of the fastening means (1) form a positive and or non-positive snap lock with corresponding snap means (25) of the fourth component (24).
